# EUROPEAN PATENT APPLICATION

(11) **EP 1 229 653 A1**
(43) Date of publication of application: **07.08.2002**
(21) Application number: 01200401.6
(22) Date of filing: 02.02.2001
(51) Int. Cl.: H03L 7/00

(54) **Feedback loop with slew rate limiter**

(71) Applicant: Semiconductor Ideas to The Market (ItoM) BV, 4839 AH Breda (NL)
(72) Inventor: Kasperkovitz, Wolfdietrich Georg, 5581 HA Waaire (NL)
(74) Representative: Van Straaten, Joop

(57) **Abstract**

In order to improve the performance of a feed back comprising a loop filter in terms of loop selectivity, stability and robustness the loop filter is being provided with a slew rate limiter.

## Description

The invention relates to a feedback loop comprising a loop filter. Feedback loops are widely used in particular in receivers, such as disclosed e.g. in U.S. Pat. No. 4,905,307. Typical applications of feedback loops are for instance phase locked loop devices for e.g. generating a synchronous local carrier frequency and AGC loop systems for level stabilisation. Phase-locked loop devices are usually provided with a phase detection device, a loop filter and a controlled oscillator, a reference frequency being applied to said phase detection device. Such reference frequency may be supplied by a crystal oscillator, or may be derived from an RF or IF carrier frequency or a pilot signal frequency, such as used in FM stereo multiplex signals. In the phase-locked state of the loop, phase differences between the oscillator signal, on the one hand, and the reference frequency, on the other hand, are converted in the phase detection device into a phase difference signal which is selected by the loop filter and negatively fed back as a loop control signal to the input of the phase detection device and is thereby suppressed. This results in a phase synchronization of the oscillator signal with the reference frequency. AGC loop systems usually comprise a gain controlled amplifier, a level detector and a level referencing device, determining the difference between the output signal level of said gain controlled amplifier and a set level value, which level difference is negatively fed back to a gain control input of the gain controlled amplifier and therewith suppressed.

For a correct operation of the feedback loop, the loop parameters should satisfy requirements, which in conventional implementation, are mutually conflicting. For instance, in a phase-locked loop the loop selectivity has to be large for an accurate phase synchronization. However, a large loop selectivity is accompanied by a large phase shift which jeopardizes the loop stability. This also applies mutatis mutandis to an AGC loop.

A first object of the invention is to improve substantially the performance of feed back loops in terms of robustness and stability.

A second object of the invention to increase the loop selectivity of feedback loops.

A third object of the invention is to simplify the circuitry and production costs of feedback loops.

A feedback loop comprising a loop filter in accordance with the invention is therefore characterized in that the loop filter comprises a slew rate limiter.

Slew rate limiters are on themselves known e.g. from US patent number 5,417,221. The invention however is based on the recognition that a slew rate limiter although being non linear dramatically improves the performance of a feed back loop if being applied as a loop filter in such loop to select the loop control signal.

By applying the measure according to the invention, the signal slew rate rather than the signal frequency is used as criterium to discriminate between the useful, wanted loop signal and unwanted interference signals or distortions. As on itself known, the slew rate of a signal is defined by the product of its amplitude and frequency. The slew rate limiter according to the invention is unable to provide output signals having a slew rate exceeding the maximum slew rate of the slew rate limiter itself and is substantially transparent to signals having a slew rate smaller than said maximum slew rate. This means that only signals having a product of amplitude and frequency smaller than said maximum slew rate pass the slew rate limiter unaffected in phase and/or amplitude. Input signals having a slew rate exceeding said maximum slew rate appear at the output of the slew rate limiter with a slew rate corresponding to said maximum slew rate. These input signals are therewith limited in the product value of their respective amplitudes and frequencies.

This is in particular advantageous in a PLL used for carrier recovery e.g. in receivers such as mobile, radio or television or in modems. Such PLL feedback loop is characterized by a phase detector for detecting phase differences between an input signal and a reference signal, an output thereof being coupled through said slew rate limiter to a control input of a controlled oscillator, supplying said reference signal to the phase detector. With an appropriate value for the maximum slew rate, the slew rate limiter is transparent for, i.e. does not change the phase and/or amplitude of, the wanted small and low frequency loopsignal. Adjacent RF carriers have much higher frequencies, which will cause the slew rate thereof to reach the maximum slew rate already at relatively low amplitudes. The higher the signal frequency, the lower the amplitude, at which the maximum slew rate is reached. This results in an effective removal of unwanted signals, interferences and distortions no matter how large the amplitude thereof is.

Another advantageous application is in an AGC feedback loop, which according to the invention is characterized by a gain controlled amplifier, an output thereof being coupled through said loop filter to a level comparator for comparing the level of the output signal of the loop filter with a reference level, an output of said comparator being coupled to a gain control input of said gain controlled amplifier.

Also here, the slew rate limiter provides an effective removal of unwanted signals, interferences and distortions from the loop control signal, independent from the amplitude thereof.

A preferred embodiment of a feedback loop according to the invention is characterized in that the slew rate limiter comprises a first transconductance amplifier having a differential signal input with positive and negative input terminals, an input signal voltage being supplied to the positive input terminal, an output signal current supplied to a mass connected capacitor and fed back to the negative input terminal of the differential input, said first transconductance amplifier being controlled by a gain control current, the maximum slew rate of the slew rate limiter being determined by the capacitance value of the capacitor and said gain control current.

This measure allows for a robust implementation of the slew rate limiter as non-linear loop filter providing simple setting of the maximum slew rate.

For a cost effective circuit implementation, the first transconductance amplifier preferably includes a differential pair of first and second transistors, the base electrodes thereof constituting said differential input, the emitters being coupled in common to a controllable current source, said input signal voltage being coupled to the base electrode of the first transistor and a collector of said differential pair being coupled to said output and negatively fed back through the mass connected capacitor to the base electrode of the second transistor.

Preferably, the collectors of the first and second transistor being coupled to inputs of first and second current mirrors, the output of said first current mirrors being coupled to an input of a third current mirror and outputs of said second and third current mirrors being coupled in common to the output of the transconductance amplifier. Although easy to implement, such embodiment, however, is inherently asymmetric in the amplification of the input signals, giving rise to e.g. DC offset. This prevents the latter transconductance amplifier from being used as part of a slew rate limiter in a phase locked loop.

A preferred embodiment of a slew rate limiter which is well suited for use in a phase locked loop is characterized by a second transconductance amplifier corresponding to said first transconductance amplifier, a pair of mutually identical input signals in phase opposition being supplied to the inputs of said first and second transconductance amplifiers and outputs thereof being coupled to a differential input of a third transconductance amplifier providing an output signal current varying with the differential input voltage. This measure provides accurate symmetrical signal processing, therewith securing an appropriate functioning of the loop.

Another preferred embodiment of a feedback loop according to the invention is characterized in that the slew rate limiter comprises a cascade of a differentiating device, a limiter amplifier and an integrating device.

Preferably, the maximum slew rate of such slew rate limiter is being determined by the limiting level of the limiter amplifier.

These and further aspects and advantages of the invention will be discussed more in detail hereinafter with reference to the disclosure of preferred embodiments, and in particular with reference to the appended Figures in which like reference numerals refer to like elements wherein:
Figure 1 is a schematic diagram of a first preferred embodiment of a PLL feed back loop according to the invention;
Figure 2 is a schematic diagram of a preferred embodiment of a slew rate limiter in accordance with the invention;.
Figure 3 is a schematic diagram of a preferred embodiment of a phase locked loop according to the invention;
Figure 4 is a schematic diagram of a preferred embodiment of a AGC feed back loop according to the invention;
Figure 5 is a signal graph showing the effect of the slew rate limiter of Figures 2 and 3 on signals with various slew rates in the amplitude/frequency domain.
Figure 6 is a signal graph showing the effect of the slew rate limiter of Figures 2 and 3 on signals with various slew rates in the time domain;

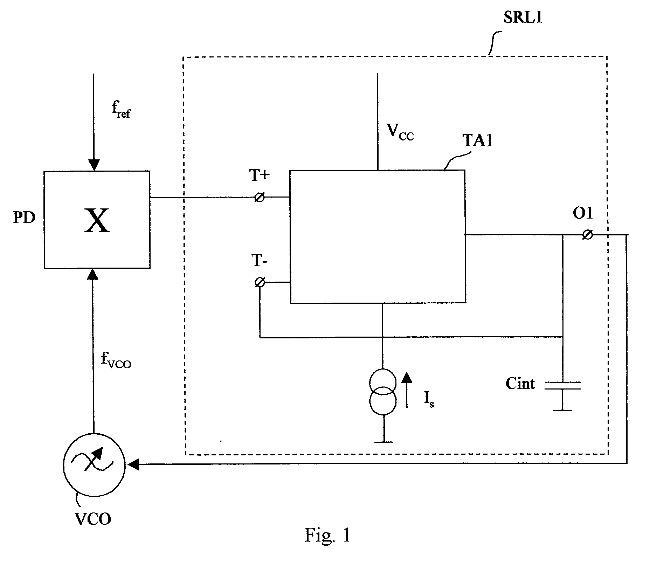

Figure 1 shows a first preferred embodiment of a PLL feed back loop according to the invention comprising a phase detection device PD being supplied by a reference frequency fref and followed by a first slew rate limiter SRL1 functioning as loopfilter. An output of the first slew rate limiter SRL1 supplies a loop signal voltage to a phase/frequency control input of a voltage controlled oscillator VCO, providing a local oscillator signal fvco to the phase detection device PD.

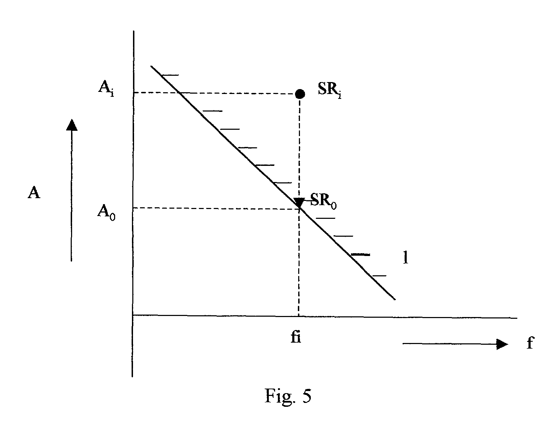

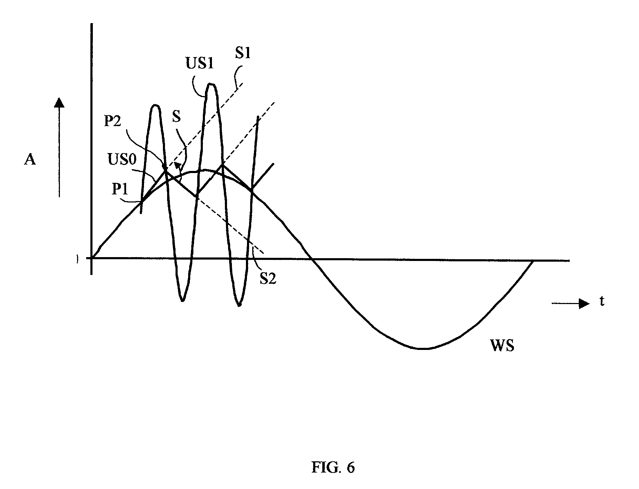

The first slew rate limiter SRL1 comprises a first transconductance amplifier TA1 having a differential signal input with positive and negative input terminals T+ and T, respectively. The wanted phase difference between the reference frequency fref and the local oscillator signal fvco, as well as all other unwanted mixing products at the output signal of the phase detection device PD are being supplied to the positive input terminal of the first transconductance amplifier TA1. The first transconductance amplifier TA1 provides an output signal current at its output O1, which is supplied to a mass connected integrating capacitor Cint and fed back to its negative input terminal. T-. The output signal current varies with the differential input signal at the input terminals T+ and T, however is limited in its slew rate at the maximum slew rate of the first slew rate limiter SRL1. This maximum slew rate is adjusted to an appropriate value by means of a gain setting current Is, controlling the gain of the first transconductance amplifier TA1, and a proper choice of the capacitance value of the integrating capacitor Cint. The effect of the slew rate limiter SRL1 on input signals having various slew rates, hereinafter also indicated as input slew rates, with respect to the maximum slew rate is clarified in more detail hereinafter with reference to Figures 5 and 6.

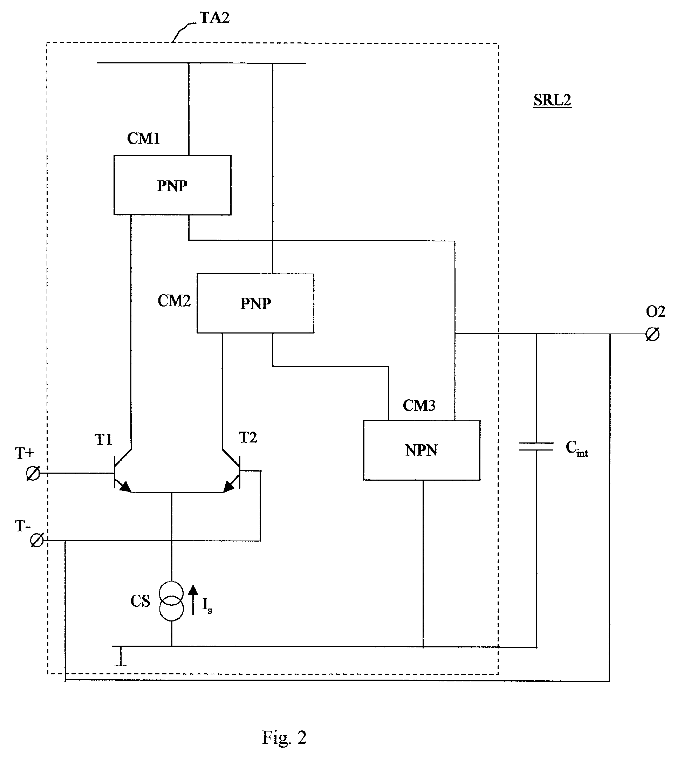

Figure 2 is a diagram of a preferred embodiment of a slew rate limiter, hereinafter being referred to as second slew rate limiter SRL2, for use in a feedback loop according to the invention, such as e.g. an AGC loop. A transconductance amplifier TA2 is used therein, which on itself is known e.g. from National Semiconductor Datasheet on IC type LM13700 Dual Operational Transconductance Amplifiers with Linearizing Diodes and Buffers. It comprises a differential pair of first and second transistors T1 and T2, the base electrodes thereof constituting the differential input of the transconductance amplifier TA2, the emitters being coupled in common to controllable current source CS supplying the above gain setting current Is setting the first transconductance amplifier TA1 at an appropriate gain factor. An input signal voltage i.e. the output signal of the phase detection device PD, is coupled to the positive input terminal T+ of the transconductance amplifier TA2 being constituted by the base electrode of the first transistor T1. A collector electrode of the first transistor T1 is being coupled through current mirrors CM1-CM3 to the output O of the transconductance amplifier TA2 and negatively fed back through the mass connected capacitor Cint to the negative input terminal T- of the transconductance amplifier TA2, being constituted by the base electrode of the second transistor T2. Such current mirrors are on themselves known, the first and second current mirrors CM2 and CM3 being PNP type current mirrors, the third current mirror CM3 being a NPN type current mirror. The collector electrode of the first transistor T1 is coupled to an input of the first current mirror CM1, in which the collector current of the first transistor T1 is mirrored and available at the output thereof. The collector electrode of the second transistor T2 is coupled to an input of the second current mirror CM2, in which the collector current of the second transistor T2 is mirrored. An output of the second current mirror CM2 is coupled to an input of the third current mirror CM3, in the second current mirror CM2 and supplied as input current to the third current mirror CM3. The third current mirror CM3 therewith provides an output current substantially equal to the collector current of the second transistor T2. Outputs of both first and third current mirror CM1 and CM3 are commonly coupled to the output O of the transconductance amplifier TA2. The output current of the transconductance amplifier TA2 being supplied to the capacitor Cint, therewith corresponds substantially to the difference between the collector currents of the first and second transistors T1 and T2, varying with the differential input voltage at the differential input T+, T-. The maximum slew rate is determined by the quotient I/C, I corresponding substantially to the current Is of the current source CS and C being the capacitance value of the capacitor Cint.

However, due to the signal loss in each current mirror, hereinafter being referred to as mirror loss, the output current of the third current mirror CM3 differs twice the mirror loss from the collector current of the second transistor T2, whereas the output current of the first current mirror CM1 only differs one mirror loss from the collector current of the first transistor T1. This asymmetry is inherent to most existing transconductance amplifiers, and causes DC offset and asymmetrical signal processing to occur, making the slew rate limiters including such transconductance amplifiers unsuitable for use in PLLs.

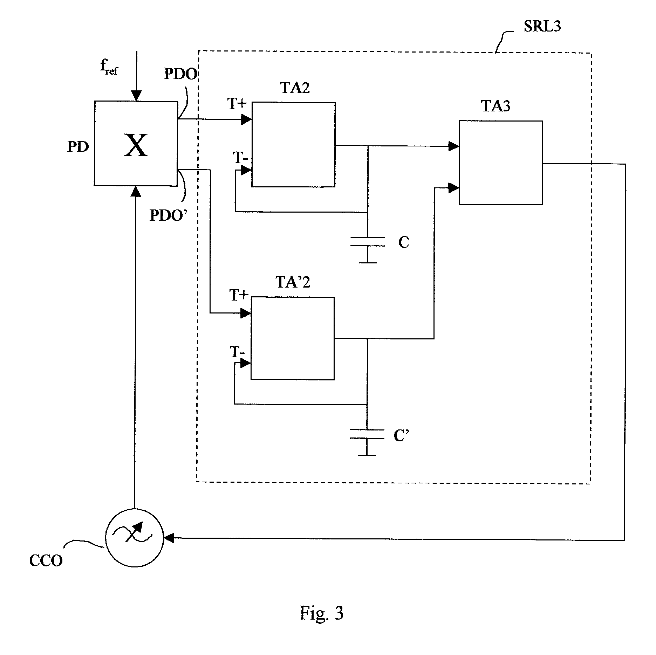

Figure 3 is a schematic diagram of a second preferred embodiment of a PLL according to the invention comprising a phase detection device PD being supplied by a reference frequency fref and followed by a third slew rate limiter SRL3 functioning as loopfilter. An output of the third slew rate limiter SRL3 supplies a loop current signal to a phase/frequency control input of a current controlled oscillator CCO, providing a local oscillator signal fcco to the phase detection device PD. The phase detection device PD is provided with a differential output with first and second output terminals PDO and PDO' supplying a differential output signal, i.e. pair of mutually identical output signals in phase opposition. The third slew rate limiter SRL3 is being provided with a pair of transconductance amplifier TA2 and TA2' each corresponding to the transconductance amplifier TA2 of Figure 2. The first and second output terminals PDO and PDO' of the phase detection device PD are coupled to coupled to the positive input terminals T+ of the transconductance amplifier TA2 and TA2' respectively. The outputs of the transconductance amplifier TA2 and TA2' are coupled to a differential input of a third transconductance amplifier TA3, providing an output signal current varying with the differential input voltage. The asymmetry of the transconductance amplifier TA2 compensates the identical but opposite asymmetry of the transconductance amplifier TA2', resulting in an accurate symmetrical signal processing allowing for the use of such third slew rate limiter SRL3 in PLLs.

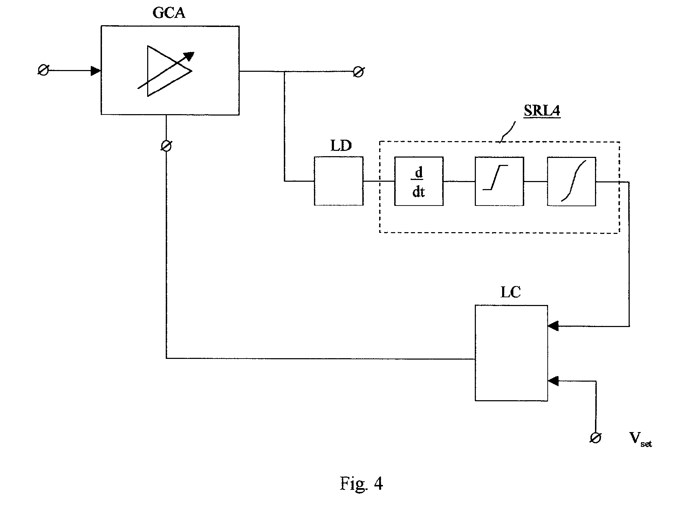

Figure 4 shows a preferred embodiment of a AGC feed back loop according to the invention comprising a gain controlled amplifier GCA, an output thereof being coupled through a level detector to a second slew rate limiter SRL2 functioning as AGC loop filter. The second slew rate limiter SRL2 is followed by a level comparator LC for comparing the level of the output signal of the loop filter with a reference level, an output of said comparator LC being coupled to a gain control input of said gain controlled amplifier GCA.

The second slew rate limiter SRL2 comprises a cascade of a differentiating device DIF, a limiter amplifier LA and an integrating device INT. The maximum slew rate of the second slew rate limiter SRL2 is determined by the limiting level of the limiter amplifier LA.

Figure 5 is a signal graph showing the effect of the slew rate limiter according to the invention on signals with various slew rates in the frequency domain. The maximum slew rate is given with line 1. Input signals having an amplitude and frequency within the area at the left hand side of the line 1 pass through the slew rate limiter unaffected in phase and amplitude. Input signals having an amplitude and frequency beyond said area, i.e. being positioned with respect to their amplitude and frequency at the right hand side of the line 1, are reduced in amplitude to a value on the line 1. For example a signal having an input slew rate indicated in the Figure with position Sri at (fi, Ai) is reduced in amplitude to an output slew rate indicated with Sro at (fi, A0). The slew rate limiter therewith effectuates a reduction in amplitude of (Ai-A0). Furthermore the slew rate limitation is effected at amplitudes which decrease with increasing frequencies. The higher the frequency of the signal, the lower the amplitude at which slew rate limiter effectuates an amplitude reduction, or in other words the more effective such signal is suppressed.

Figure 6 is a signal graph showing the effect of a slew rate limiter according to the invention, such as e.g. the one showed in Figure 2, on signals with various slew rates in the time domain. Curve WS illustrates the time variant amplitude of a first signal having an input slew rate smaller than the maximum slew rate of the slew rate limiter. Such first signal remains unaffected in gain and amplitude while passing through the slew rate limiter, resulting in an output signal similar to the input signal and therefore also being represented by curve WS. Curve USi illustrates the time variant amplitude of a second signal having an input slew rate greater than the maximum slew rate of the slew rate limiter and being superposed on the first signal. Curve USo illustrates the time variant amplitude of the combined first and second signals at the output of a slew rate limiter. An upswing variation of curve Usi starting at point P causes the output signal of the slew rate limiter to increase in amplitude at the maximum slew rate as given by the line S1. The limitation in slew rate effectuates a gradual clipping in amplitude of the second signal during the period Usi exceeds Uso. At the point P1 at which curves Usi and Uso cross, the downswing of the second signal as from this point P2, will cause the output signal of the slew rate limiter to decrease in amplitude at the maximum slew rate as given by the line S2. Also here, the limitation in slew rate effectuates a gradual clipping in amplitude of the second signal, now occurring during the period Usi is below Uso, and so forth and so on. Only for input slew rates within the angle S between the lines S1 and S2, the output signal of the slew rate limiter will vary in accordance with the input signal. Unlike conventional low pass filters, this amplitude clipping is independent from the actual amplitude of the input signal and is effective at lower amplitudes, the higher their frequency. Furthermore small DC or low frequency signals remain unchanged in phase and amplitude. The inventor has recognized that the use of a slew rate limiter in a feedback loop as loop filter instead of a conventional low pass filter dramatically improves the performance of this feed back loop in terms of stability, control accuracy and robustness. Furthermore the circuit complexity of such feedback loop is very low allowing costeffective implementation in IC technology.

While the invention has been particularly shown and described with reference to the preferred embodiments thereof, it will be understood by those skilled in the art that various changes in form and details may be made without departing from the spirit and scope of the invention. For instance, the first transconductance amplifier TA1 may use a differential pair of transistors similar to the differential pair of first and second transistors T1 and T2 of the second transconductance amplifier TA2, the collector output current of one of said pair of transistors being mirrored in a single PNP type current mirror and combined with the collector output current of the other transistor of said pair of transistors the form the difference between these currents for supply to the output O1 of the first transconductance amplifier TA1 (not shown).

The voltage controlled oscillator VCO in Figure 1 may well be replaced by a current controlled oscillator, whereas the current controlled oscillator CCO in Figure 3 may well be replaced by a voltage controlled oscillator VCO by applying a suitable voltage to current conversion preceding the oscillator.

## Claims

1. Feedback loop comprising a loop filter, **characterized in that** the loop filter comprises a slew rate limiter.

2. Feedback loop according to claim 1, **characterized by** a phase detector for detecting phase differences between an input signal and a reference signal, an output thereof being coupled through said slew rate limiter to a control input of a controlled oscillator, supplying said reference signal to the phase detector.

3. Feedback loop according to claim 1, **characterized by** a gain controlled amplifier, an output thereof being coupled through said loop filter to a level comparator for comparing the level of the output signal of the loop filter with a reference level, an output of said comparator being coupled to a gain control input of said gain controlled amplifier.

4. Feedback loop according to one of claims 1 to 3, **characterized in that** the slew rate limiter comprises a first transconductance amplifier having a differential signal input with positive and negative input terminals, an input signal voltage being supplied to the positive input terminal, an output signal current supplied to a mass connected capacitor and fed back to the negative input terminal of the differential input, said transconductance amplifier being controlled by a gain control current, the maximum slew rate of the slew rate limiter being determined by the capacitance value of the capacitor and said gain control current.

5. Feedback loop according to claim 4, **characterized by** said first transconductance amplifier including a differential pair of first and second transistors, the base electrodes thereof constituting said differential input, the emitters being coupled in common to a controlled current source, said input signal voltage being coupled to the base electrode of the first transistor and a collector of said differential pair being coupled to said output and negatively fed back through the mass connected capacitor to the base electrode of the second transistor.

6. Feedback loop according to claim 5, **characterized by** the first transconductance amplifier having the collectors of the first and second transistor being coupled to inputs of first and second current mirrors, the output of said first current mirrors being coupled to an input of a third current mirror and outputs of said second and third current mirrors being coupled in common to the output of the transconductance amplifier.

7. Feedback loop according to claim 6, **characterized by** a second transconductance amplifier corresponding to said first transconductance amplifier, a pair of mutually identical input signals in phase opposition being supplied to the inputs of said first and second transconductance amplifiers and outputs thereof being coupled to a differential input of a third transconductance amplifier providing an output signal current varying with the differential input voltage.

8. Feedback loop according to one of claims 1 to 3, **characterized in that** the slew rate limiter comprises a cascade of a differentiating device, a limiter amplifier and an integrating device.

9. Feedback loop according to claim 8, **characterized by** the maximum slew rate of the slew rate limiter being determined by the limiting level of the limiter amplifier.

10. Slew rate limiter for use in a feedback loop according to one of claims 1 to 9.
